# EUROPEAN PATENT SPECIFICATION

(11) **EP 4 572 567 B1**
(45) Date of publication and mention of the grant of the patent: **28.10.2026**
(21) Application number: 24213905.3
(22) Date of filing: 19.11.2024
(51) Int. Cl.: H10D 89/60, H10D 8/00, H10D 18/00, H10D 30/62, H10D 62/10, H10D 62/13

(54) **LOW CAPACITANCE SILICON CONTROLLED RECTIFIER TOPOLOGY FOR OVERVOLTAGE PROTECTION**
SILIZIUMGESTEUERTE GLEICHRICHTERTOPOLOGIE MIT NIEDRIGER KAPAZITÄT FÜR ÜBERSPANNUNGSSCHUTZ
TOPOLOGIE DE REDRESSEUR COMMANDÉ AU SILICIUM À FAIBLE CAPACITÉ POUR PROTECTION CONTRE LES SURTENSIONS

(30) Priority: 08.12.2023 US 202318533942
(43) Date of publication of application: 18.06.2025
(73) Proprietor: Analog Devices, Inc., Wilmington, MA 01887 (US)
(72) Inventor: PARTHASARATHY, Srivatsan, Wilmington 01887 (US); SALCEDO, Javier A., Wilmington 01887 (US); HAJJAR, Jean-Jacques, Wilmington 01887 (US); ZHOU, Yuanzhong, Wilmington 01887 (US); PILLING, Tom, Wilmington 01887 (US)
(74) Representative: Yang, Shu

(56) References cited:
- CN-A- 112 397 505
- US-A- 5 541 801
- US-B2- 11 595 036
- PARTHASARATHY SRIVATSAN ET AL: "Device for Protecting High Frequency and High Data Rate Interface Applications in FinFET Process Technologies", 2022 IEEE RADIO FREQUENCY INTEGRATED CIRCUITS SYMPOSIUM (RFIC), IEEE, 19 June 2022 (2022-06-19), pages 203 - 206, XP034185269, DOI: 10.1109/RFIC54546.2022.9863162

## Description

### Field of the Disclosure

Embodiments of the invention relate to electronic systems, and more particularly to, electrical overvoltage protection for radio frequency signal interfaces.

### BACKGROUND

Electronic systems can be exposed to electrical overstress events, or electrical signals of short duration having rapidly changing voltage and high power. Such electrical overstress events can occur during manufacturing, assembly, and/or end-user application environment. Electrical overstress events include, for example, electrical overstress (EOS), electromagnetic interference (EMI), and electrostatic discharge (ESD) arising from the abrupt release of charge from an object or person to an electronic system. The design constraints to safely handle these type of environmental overstress conditions are particularly complex in fin field-effect-transistor (FinFET) systems-on-a-chip (SoC) for high frequency applications.

Electrical overstress events can damage or destroy integrated circuits (ICs) by generating overvoltage conditions and high levels of power dissipation in relatively small areas of the ICs. High power dissipation can increase IC temperature, and can lead to numerous problems, such as gate oxide punch-through, junction damage, metal damage, and surface charge accumulation. US11595036B2 discloses fin field-effect transistor (FinFET) thyristors for protecting high-speed communication interfaces. In certain embodiments herein, high voltage tolerant FinFET thyristors are provided for handling high stress current and high RF power handling capability while providing low capacitance to allow wide bandwidth operation. Thus, the FinFET thyristors can be used to provide electrical overstress protection for ICs fabricated using FinFET technologies, while addressing tight radio frequency design window and robustness. In certain implementations, the FinFET thyristors include a first thyristor, a FinFET triggering circuitry and a second thyristor that serves to provide bidirectional blocking voltage and overstress protection. The FinFET triggering circuitry also enhances turn-on speed of the thyristor and/or reduces total on-state resistance.

### SUMMARY OF THE DISCLOSURE

Low capacitance silicon controlled rectifier (SCR) topologies for overvoltage protection are disclosed herein.

According to the invention there is provided an overvoltage protection circuit as defined in claim 1, and a method of protecting an integrated circuit, IC, from electrical overstress as defined in claim 15. Further developments of the invention are the subject of the dependent claims.

In certain embodiments, an overvoltage protection circuit is connected between an RF signal pad and a ground signal pad. The overvoltage protection circuit includes a FinFET SCR including a PNP bipolar transistor and an NPN bipolar transistor that are cross-coupled, a FinFET trigger circuit connected between an emitter of the PNP bipolar transistor and a base of the NPN bipolar transistor, and a linearity enhancement impedance connected between a reference voltage terminal and the emitter of the PNP bipolar transistor. In certain implementations, a FinFET diode is further included in series with the FinFET SCR with a cathode of the FinFET diode connected to the emitter of the PNP bipolar transistor. By including the linearity enhancement impedance, RF signals are impeded or inhibited (for example, blocked) from reaching the reference voltage terminal. Thus, the linearity of the overvoltage protection circuit is improved. Further, the linearity enhancement impedance aids in biasing the emitter of the PNP bipolar transistor with a reference voltage for low capacitance operation. Accordingly, the resulting protection structure is both linear and low capacitance. Further, by including the FinFET trigger circuit, high speed activation with low trigger voltage is achieved.

In one aspect, an integrated circuit (IC) includes a radio frequency (RF) signal pad, a ground pad, and an overvoltage protection circuit connected between the RF signal pad and the ground pad and configured to activate in response to an electrical overvoltage condition received between the RF signal pad and the ground pad. The overvoltage protection circuit comprises a first fin field-effect transistor (FinFET) silicon controlled rectifier (SCR) including a first PNP bipolar transistor and a first NPN bipolar transistor, wherein a collector of first NPN bipolar transistor is connected to a base of the first PNP bipolar transistor, and a base of the first NPN bipolar transistor is connected to a collector of the first PNP bipolar transistor, a fin field-effect transistor (FinFET) trigger circuit connected between an emitter of the first PNP bipolar transistor and the base of the first NPN bipolar transistor, and a linearity enhancement impedance connected between a reference voltage terminal and the emitter of the first PNP bipolar transistor, the linearity enhancement impedance configured to inhibit coupling of a RF signal from the RF signal pad to the reference voltage terminal.

In another aspect, an overvoltage protection circuit for protecting a radio frequency (RF) signal pad and a ground pad of an integrated circuit (IC) is provided. The overvoltage protection circuit includes a first fin field-effect transistor (FinFET) silicon controlled rectifier (SCR) including a first PNP bipolar transistor and a first NPN bipolar transistor, wherein a collector of first NPN bipolar transistor is connected to a base of the first PNP bipolar transistor, and a base of the first NPN bipolar transistor is connected to a collector of the first PNP bipolar transistor, a fin field-effect transistor (FinFET) trigger circuit connected between an emitter of the first PNP bipolar transistor and the base of the first NPN bipolar transistor, and a linearity enhancement impedance connected between a reference voltage terminal and the emitter of the first PNP bipolar transistor, the linearity enhancement impedance configured to inhibit coupling of a RF signal from the RF signal pad to the reference voltage terminal.

In another aspect, a method of protecting an integrated circuit (IC) from electrical overstress is provided. The method includes receiving an electrical overvoltage condition between a radio frequency (RF) signal pad and a ground pad, conducting a trigger current in response to the electrical overvoltage condition using a fin field-effect transistor (FinFET) trigger circuit that is connected between an emitter of a first PNP bipolar transistor and a base of a first NPN bipolar transistor, activating the FinFET SCR in response to the trigger current, wherein the FinFET SCR includes the first PNP bipolar transistor and the first NPN bipolar transistor, wherein a collector of first NPN bipolar transistor is connected to a base of the first PNP bipolar transistor, and a base of the first NPN bipolar transistor is connected to a collector of the first PNP bipolar transistor, and inhibiting coupling of a RF signal from the RF signal pad using a linearity enhancement impedance connected between a reference voltage terminal and the emitter of the first PNP bipolar transistor.

### BRIEF DESCRIPTION OF THE DRAWINGS

Figure 1A is a schematic diagram of one embodiment of an integrated circuit (IC) including a silicon controlled rectifier-based (SCR-based) overvoltage protection circuit.
Figure 1B is a schematic diagram of another embodiment of an IC including an SCR-based overvoltage protection circuit.
Figure 1C is a schematic diagram of an SCR-based overvoltage protection circuit according to one embodiment.
Figure 1D is a schematic diagram of an SCR-based overvoltage protection circuit according to another embodiment.
Figure 2 is a perspective view of a fin field-effect transistor (FinFET) according to one embodiment.
Figure 3A is one embodiment of a capacitance model for an SCR-based overvoltage protection circuit.
Figure 3B is a graph of one example of capacitance versus voltage for an SCR-based overvoltage protection circuit.
Figure 3C is a graph of one example of amplitude versus frequency for an SCR-based overvoltage protection circuit undergoing two tone testing.
Figure 4A is a plan view of a FinFET SCR-based protection structure according to one embodiment.
Figure 4B is a perspective view of an SCR section of the FinFET SCR-based protection structure of Figure 4A.
Figure 4C is one embodiment of a circuit diagram for the FinFET SCR-based protection structure of Figures 4A-4B.
Figure 4D is another embodiment of a circuit diagram for the FinFET SCR-based protection structure of Figures 4A-4B.
Figure 5 is a perspective view of an SCR section of a FinFET SCR-based protection structure according to another embodiment.
Figure 6A is a plan view of a FinFET SCR-based protection structure according to another embodiment.
Figure 6B is one embodiment of a circuit diagram for the FinFET SCR-based protection structure of Figure 6A.

### DETAILED DESCRIPTION

The following detailed description of embodiments presents various descriptions of specific embodiments of the invention. However, the invention can be embodied in a multitude of different ways. In this description, reference is made to the drawings where like reference numerals may indicate identical or functionally similar elements. It will be understood that elements illustrated in the figures are not necessarily drawn to scale. Moreover, it will be understood that certain embodiments can include more elements than illustrated in a drawing and/or a subset of the elements illustrated in a drawing. Further, some embodiments can incorporate any suitable combination of features from two or more drawings.

Certain electronic systems include overvoltage protection circuits to protect circuits and/or components from electrical overstress events. To help guarantee that an electronic system is reliable, manufacturers test such electronic systems under defined stress conditions, which can be described by standards set by various organizations, such as the Joint Electronic Device Engineering Council (JEDEC), the International Electrotechnical Commission (IEC), and the Automotive Engineering Council (AEC). The standards can cover a wide multitude of electrical overstress events, including electrical overstress (EOS) and/or electrostatic discharge (ESD).

A number of design challenges are present for protecting radio frequency (RF) circuits from electrical overstress events, particularly when such RF circuits are fabricated using FinFET processes. For example, the performance of RF circuits is degraded by capacitive loading and/or non-linearity arising from the presence of electrical overvoltage protection structures along RF signal paths. Furthermore, FinFET gate structures are easily damaged in response to electrical overstress conditions, thus rendering RF circuits fabricated with a FinFET process particularly susceptible to damage.

Conventional diode-based RF input-output (IO) protection poses significant limitations in achieving RF performance for advancing 5G communication requirements while preserving interface robustness.

For example, diode-based protection structures can suffer from slow reaction time and/or large voltage overshoot when subjected to fast ESD transients. Such large voltage overshoots can damage thin oxides being protected in advanced nm process nodes, such as complementary metal oxide semiconductor (CMOS) FinFET technologies of 16nm or less.

Additionally, diode-based protection structures can have high trigger voltage that allows for large voltage build-up before activation. Moreover, diode-based protection structures can suffer from high capacitance and/or non-linearity that can degrade RF performance during normal operation when electrical overstress events are not present.

Low capacitance silicon controlled rectifier (SCR) topologies for overvoltage protection are disclosed herein. In certain embodiments, an overvoltage protection circuit is connected between an RF signal pad and a ground signal pad. The overvoltage protection circuit includes a FinFET SCR including a PNP bipolar transistor and an NPN bipolar transistor that are cross-coupled, a FinFET trigger circuit connected between an emitter of the PNP bipolar transistor and a base of the NPN bipolar transistor, and a linearity enhancement impedance connected between a reference voltage terminal and the emitter of the PNP bipolar transistor. In certain implementations, a FinFET diode is further included in series with the FinFET SCR with a cathode of the FinFET diode connected to the emitter of the PNP bipolar transistor.

By including the linearity enhancement impedance, RF signals are impeded (for example, blocked) from reaching the reference voltage terminal. Thus, the linearity of the overvoltage protection circuit is improved. Further, the linearity enhancement impedance aids in biasing the emitter of the PNP bipolar transistor with a reference voltage for low capacitance operation. Accordingly, the resulting protection structure is both linear and low capacitance. Further, by including the FinFET trigger circuit, high speed activation with low trigger voltage is achieved.

The SCR-based protection structure can be fabricated in a variety of advanced technologies, including CMOS FinFET process nodes of 16nm or less.

The anode terminal and the cathode terminal of the SCR-based protection structure can be connected to provide protection to an RF circuit, which can be fabricated with the SCR-based protection structure on a common integrated circuit (IC). In certain implementations, the anode terminal connects to the RF signal pad of the IC while the cathode terminal connects to the ground signal pad of the IC. Thus, the SCR-based protection structure can be ground-referenced and used to protect an RF circuit formed on a common IC.

Furthermore, in certain implementations, an additional instantiation of the SCR-based protection structure is included with the anode terminal connected to the ground signal pad and the cathode connected to the RF signal pad. By including a pair of SCR-based protection structures connected in this manner, both forward and reverse overvoltage protection can be achieved.

In one example, the SCR-based protection structure protects an RF signal pad or port operating with asymmetrical signal swings in the range of +5.0V/-5.0V and having an operating frequency of about 20 GHz or higher. However, the SCR-based overvoltage protection circuits herein can be deployed in other configurations and operating scenarios.

The n-well (NW) and p-well (PW) of the SCR-based protection structure can be isolated from the substrate (for example, a p-type substrate or PSUB) by deep n-type well (DNW). In certain implementations, rather than directly connected the DNW to a power supply voltage (for example, a highest available supply voltage with the aim of preventing parasitic diodes between the PW and DNW and/or between the substrate and DNW from becoming forward biased), a resistor or other biasing circuit is included between the power supply voltage and DNW.

By connecting the DNW in this manner, linearity performance is improved by blocking a potential path between the anode terminal and the power supply voltage for RF signals. Furthermore, connecting the DNW in this manner allows biasing of the DNW to a desired electrical potential to achieve low capacitance. Accordingly, biasing the DNW in this manner can achieve both improved linearity and reduced capacitance relatively to an implementation in which the DNW is directly connected to the highest available supply voltage.

The SCR-based protection structure includes a PNP bipolar transistor and an NPN bipolar transistor that are cross-coupled. For example, the P+ fin regions, the NW, and the PW form the emitter, base, and collector, respectively, of the PNP bipolar transistor, while the N+ fin regions, the PW, and the NW form the emitter, base, and collector, respectively, of the NPN bipolar transistor. Additionally, the collector of the NPN bipolar transistor is connected to the base of the PNP bipolar transistor, while the collector of the PNP bipolar transistor is connected to the base of the NPN bipolar transistor.

Inclusion of the FinFET trigger circuit serves to further reduce the trigger voltage of the FinFET SCR by providing a displacement current to the base of the NPN bipolar transistor in response to an electrical overstress event. A tuning circuit (for example, a tuning resistor or other tuning element) can be included at the base of the NPN bipolar transistor to provide fine-tuned control over turn-on characteristics of the FinFET SCR. The trigger circuit can also serve to reduce DC leakage current of the FinFET SCR by biasing the base of the NPN bipolar transistor.

The SCR-based protection structures disclosed herein serve to robustly protect RF circuits and/or other core devices with high speed, high voltage tolerance, high linearity, and/or low capacitance. The SCR-based protection structures herein can achieve high linearity performance for communication systems specified to operate with RF power performance of up to 20dBM or more.

The SCR-based protection structures provide protection against electrical overstress events, which can include ESD events. Additionally, the SCR-based protection structures provide robust protection from overstress conditions with little to no degradation to RF performance parameters such as second-order harmonic distortion (HD2), third-order harmonic distortion (HD3), third-order intermodulation distortion (IMD3), and/or third-order intercept point (IP3). Furthermore, the SCR-based protection structures behave linearly with respect to capacitance and current characteristics such that presence of the protection device provides little to no interference with operation of the RF signal interface.

The teachings herein are applicable to SCR-based protection structures that protect RF signal pads handling RF signals of a wide range of frequencies, including not only RF signals between 100 MHz and 7 GHz, but also to higher frequencies, such as those in the X band (about 7 GHz to 12 GHz), the Kᵤ band (about 12 GHz to 18 GHz), the K band (about 18 GHz to 27 GHz), the Kₐ band (about 27 GHz to 40 GHz), the V band (about 40 GHz to 75 GHz), and/or the W band (about 75 GHz to 110 GHz). Accordingly, the teachings herein are applicable to protecting a wide variety of RF circuits, including microwave circuits.

Furthermore, the RF circuits protected by the SCR-based protection structures herein can be associated with a variety of communication standards, including, but not limited to, Global System for Mobile Communications (GSM), Enhanced Data Rates for GSM Evolution (EDGE), Code Division Multiple Access (CDMA), wideband CDMA (W-CDMA), 3G, Long Term Evolution (LTE), 4G, and/or 5G, as well as other proprietary and non-proprietary communications standards.

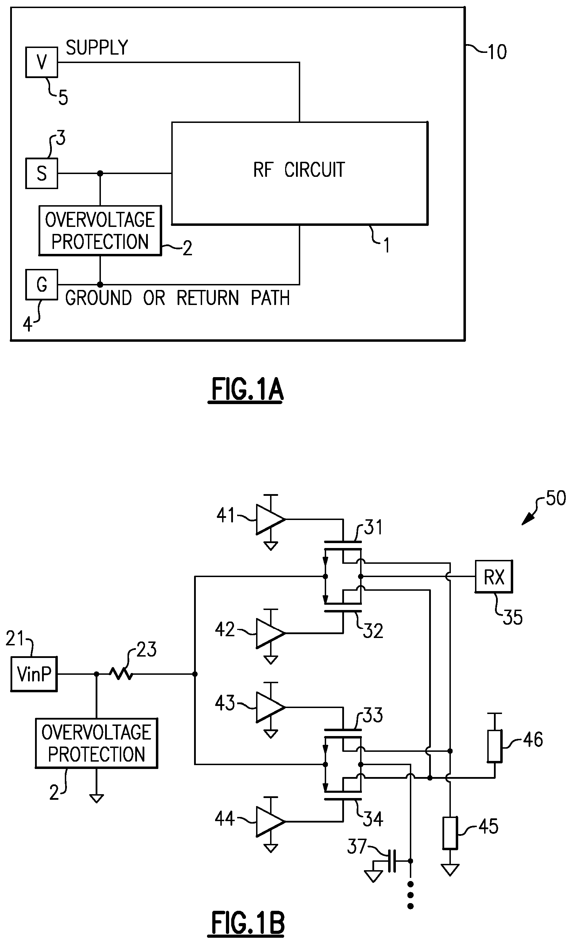

Figure 1A is a schematic diagram of one embodiment of an IC 10. The IC 10 includes an RF circuit 1, an SCR-based overvoltage protection circuit 2, an RF signal (S) pad 3, a ground (G) pad 4, and a power supply voltage (V) pad 5. An IC is also referred to herein as a semiconductor die or chip. Although certain circuits and pins of the IC 10 are shown in Figure 1A, the IC 10 can be adapted to include additional pins and/or circuitry. Such details are omitted from Figure 1A for clarity of the figure.

In the illustrated embodiment, the SCR-based overvoltage protection circuit 2 is integrated with the RF circuit 1 on a common chip. The RF circuit 1 can include one or more of wide range of high frequency circuits for handling RF signals including, but not limited to, RF amplifiers, RF mixers, RF attenuators, RF filters, RF data converters, and/or other circuitry. Although shown as protecting an RF circuit, the SCR-based protection circuits herein can also be used to protect other types of circuits and/or components.

The RF circuit 1 is connected to the RF signal pad 3, which can correspond to an input signal pad, an output signal pad, or a bidirectional signal pad. The RF circuit 1 also receives a ground voltage from the ground pad 4 and a power supply voltage from the power supply voltage pad 5.

In the illustrated embodiment, the SCR-based overvoltage protection circuit 2 includes an anode connected to the RF signal pad 3 and a cathode connected to the ground pad 4. The SCR-based overvoltage protection circuit 2 is normally in a high impedance or off state, but transitions to a low impedance or on state in response to an electrical overstress event received between the RF signal path 3 and the ground pad 4. Thus, the SCR-based overvoltage protection circuit 2 serves as a ground-referenced protection structure for providing protection against ESD and/or other electrical overstress events received on the RF signal pad 3.

A traditional ground-referenced diode-based ESD protection circuit causes high distortion due to stacking of multiple diodes to allow for large RF power handling. However, stacking multiple diodes leads to elevated distortion due to non-linearity and/or higher on-state resistance that degrades ESD performance.

In comparison, the SCR-based overvoltage protection circuit 2 of Figure 1A can be implemented with one or more features of the present disclosure to achieve low trigger voltage, low capacitance, high power handling capability, and/or high linearity.

Although Figure 1A illustrates one example application for SCR-based protection structures, the teachings herein are applicable to a wide variety of high-speed interfaces.

Figure 1B is a schematic diagram of another embodiment of an IC 50. The IC 50 includes an RF signal pad 21, an SCR-based overvoltage protection circuit 2, an input resistor 23, a first n-type field-effect transistor (NFET) 31, a first p-type field-effect transistor (PFET) 32, a second NFET 33, a second PFET 34, an RF receive circuit 35, a capacitor 37, a first driver 41, a second driver 42, a third driver 43, a fourth driver 44, a p-well (PW) biasing circuit 45 and an n-well biasing circuit 46.

The IC 50 illustrates another example application for the SCR-based protection structures disclosed herein. Although Figure 1B illustrates another example application for the SCR-based protection structures, the teachings herein are applicable to a wide variety of high-speed interfaces. In Figure 1B, half of a differential receive circuit is shown, with the RF signal pad 21 receiving a non-inverted RF signal component (VinP) of a differential RF signal. The IC 50 can further include another half of the differential receive circuit associated with an inverted RF signal component (VinN). In Figure 1B, the capacitor 37 stores a common-mode voltage of the RF signal components (VinP/VinN).

As shown in Figure 1B, the SCR-based overvoltage protection circuit 2 is connected between the RF signal pad 21 and ground. Thus, the SCR-based overvoltage protection circuit 2 is ground-referenced. Additionally, the input resistor 23 is connected between the RF signal pad 21 and an input node. Furthermore, the first NFET 31 includes a source connected to the input node, a drain connected to the RF receive circuit 35, and a gate controlled by the first driver 41. Additionally, the first PFET 32 includes a source connected to the input node, a drain connected to the RF receive circuit 35, and a gate controlled by the second driver 42. Furthermore, the second NFET 33 includes a source connected to the input node, a drain connected to the capacitor 37, and a gate controlled by the third driver 43. Additionally, the second PFET 34 includes a source connected to the input node, a drain connected to the capacitor 37, and a gate controlled by the fourth driver 44.

In the illustrated embodiment, the bodies of the first NFET 31 and the second NFET 32 are connected to ground thru the PW biasing circuit 45. Additionally, the bodies of the first PFET 33 and the second PFET 34 are connected to the supply voltage thru the NW biasing circuit 46.

Thus, rather than connected the bodies of the NFETs directly to ground and the bodes of the PFETs directly to the supply voltage, an indirect connection thru a bias circuit is used. The NW biasing circuit 45 and the PW biasing circuit 46 can correspond to resistors, diodes, switches, and/or other structures that provide impedance. By implementing the IC 50 in this manner, an indirect path from the RF signal pad 21 to the power supply during an overvoltage event is blocked. Accordingly, ground-referencing is improved.

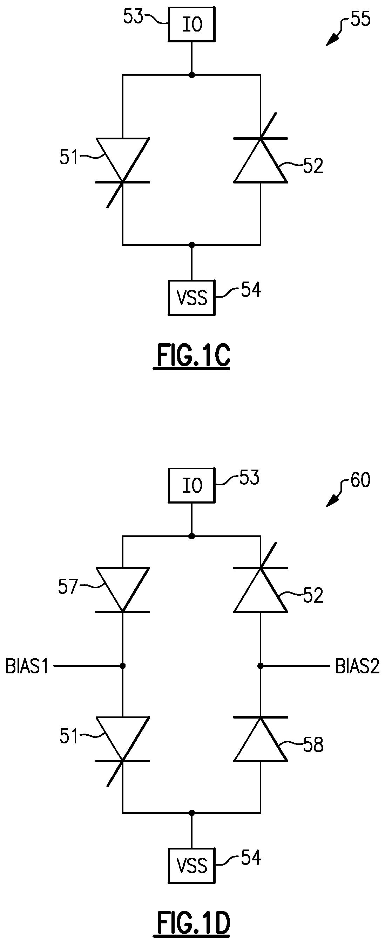

Figure 1C is a schematic diagram of an SCR-based overvoltage protection circuit 55 according to one embodiment. The SCR-based overvoltage protection circuit 55 includes a first SCR 51 having an anode connected to a signal pad 53 and a cathode connected to a ground (VSS) pad 54. Furthermore, the SCR-based overvoltage protection circuit 55 includes a second SCR 52 includes an anode connected to the ground pad 54 and a cathode connected to the signal pad 53. The signal pad 53 can be an input and/or output (IO) signal pad for receiving and/or transmitting RF signals.

In the illustrated embodiment, two SCRs are included in a parallel configuration, with one SCR 51 connected to provide forward overvoltage protection and another SCR 52 connected to provide reverse overvoltage protection. By connecting the SCRs in this manner, electrical overvoltage protection can be provided both for positive overstress events that increase the voltage of the signal pad 53 relative to the ground pad 54 and for negative overstress events that increase the voltage of the ground pad 54 relative to the signal pad 53.

Figure 1D is a schematic diagram of an SCR-based overvoltage protection circuit 60 according to another embodiment. The SCR-based overvoltage protection circuit 60 includes a first SCR 51, a second SCR 52, a first diode 57, and a second diode 58.

As shown in Figure 1D, an anode of the first diode 57 is connected to the signal pad 53 and a cathode of the first diode 57 is connected to an anode of the first SCR 51 at a node biased by a first bias signal BIAS1. Furthermore, a cathode of the first SCR 51 is connected to the ground pad 54. Additionally, an anode of the second diode 58 is connected to the ground pad 54 and a cathode of the second diode 58 is connected to an anode of the second SCR 52 at a node biased by a second bias signal BIAS2, which can be of the same or different electrical potential as the first bias signal BIAS1. Furthermore, a cathode of the second SCR 52 is connected to the signal pad 53.

The SCR-based overvoltage protection circuit 60 of Figure 1D is similar to the SCR-based overvoltage protection circuit 55 of Figure 1C, except that the SCR-based overvoltage protection circuit 60 further includes the first diode 57 in series with the first SCR 51 and the second diode 58 in series with the second SCR 52. Additionally, the intermediate node between each SCR and diode is biased by a bias voltage to aid in achieving low capacitance characteristics.

Any of the SCRs herein can be included in series with one or more diodes and/or other circuit components to aid in achieving desired forward and/or reverse protection characteristics. For example, including a diode in series with an SCR as shown in the example of Figure 1D can increase an effective trigger voltage of the SCR-based overvoltage protection circuit.

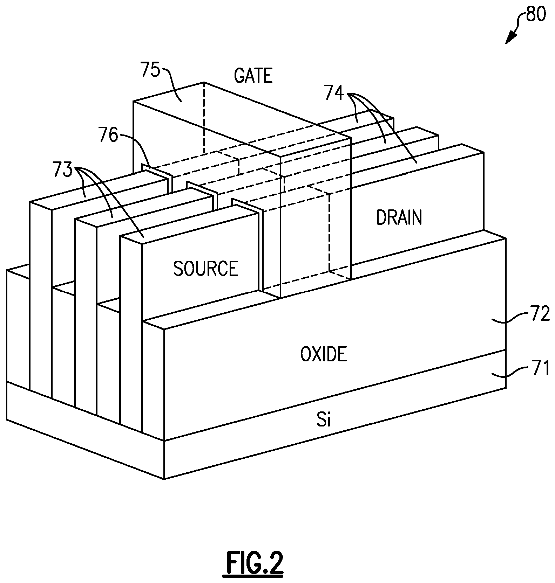

Figure 2 is a perspective view of a fin field-effect transistor (FinFET) 80 according to one embodiment. The FinFET 80 is fabricated on a silicon (Si) substrate 71, which can be doped (for example, using a p-type dopant). The FinFET 80 includes oxide regions 72 in which active fin regions have been formed. The active fin regions include source fin regions 73 and drain fin regions 74, which can be doped n-type and/or p-type as desired for a particular application. Additionally, a gate oxide region 76 and a polysilicon gate fin 75 have been formed over a portion of the active fin regions to form the FinFET 80.

The FinFET 80 can provide a number of advantages relative to other transistor technologies. For example, the FinFET 80 facilitates higher level of integration and technology scaling. Moreover, the FinFET 80 can provide higher electrical control over a channel, more effective leakage suppression, enhanced driving current, and/or higher intrinsic gain for superior analog performance.

Thus, the FinFET 80 provides a number of advantages suitable for deployment in ICs for high-speed data conversion, wide bandwidth wireless communications, and/or other high-performance applications. For instance, a semiconductor chip implemented with FinFETs can be used to enable the high-speed applications discussed above with reference to Figures 1A-1B.

Accordingly, to aid in meeting bandwidth constraints for 5G or other high performance applications, it is desirable use FinFET technology to fabricate semiconductor dies (also referred to herein as integrated circuits or ICs) for high-performance transceivers and/or high-speed interfaces.

Although FinFET technology can provide a number of advantages, such FinFETs can operate with higher parasitic resistance, higher parasitic capacitance, and/or poorer thermal characteristics (for instance, higher thermal impedance and/or more self-heating) relative to transistors fabricated using a conventional complementary metal oxide semiconductor (CMOS) process. Such characteristics can render FinFETs susceptible to damage from electrical overstress.

The teachings herein can be used to provide electrical overvoltage protection for ICs fabricated using FinFET technologies, thereby helping to meet tight design windows for robustness. For example, in certain embodiments herein, high voltage tolerant FinFET SCRs are provided for handling high stress current and high RF power handling capability, while providing low capacitance to allow wide bandwidth operation.

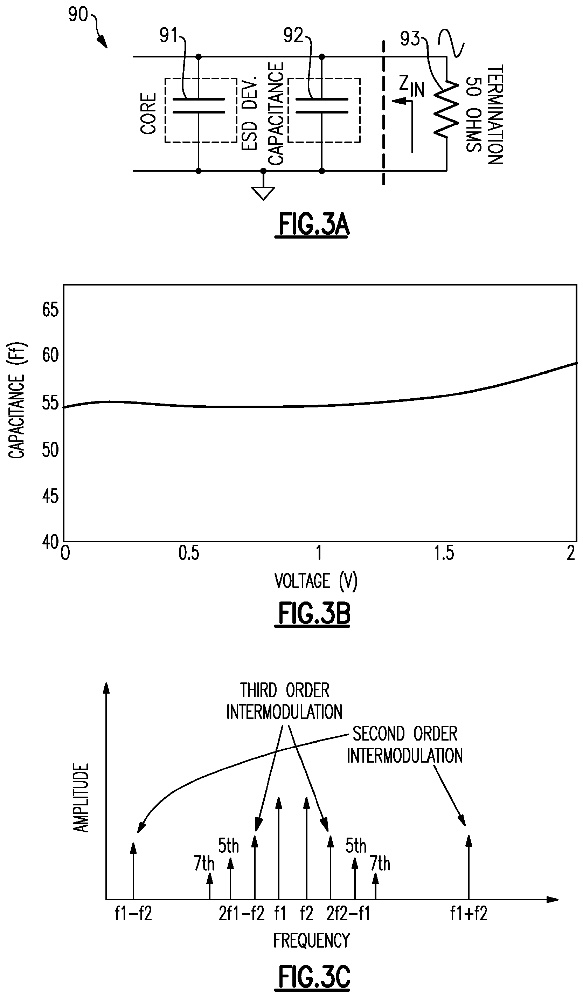

Figure 3A is one embodiment of a capacitance model 90 for an SCR-based overvoltage protection circuit. The capacitance model 90 includes a parallel combination of a core capacitance 91, an ESD device capacitance 92, and a 50 Ohm termination impedance 93. The capacitance model 90 represents loading presented to an RF signal received on an RF signal pad. Additionally, the parallel combination of the core capacitance 91 and the ESD device capacitance 92 represent an input impedance Z_{IN}.

The performance of RF circuits is degraded by capacitive loading and/or non-linearity arising from the presence of electrical overvoltage protection structures along RF signal paths. Thus, it is desirable for an electrical overstress protection structure to have capacitance that is both low and linear with respect to voltage.

Figure 3B is a graph of one example of capacitance versus voltage for an SCR-based overvoltage protection circuit. In this example, the capacitance is both low (less than 60fF) and linear (less than 5fF/V in variation) over a voltage range of 0V to 2V.

Figure 3C is a graph of one example of amplitude versus frequency for an SCR-based overvoltage protection circuit undergoing two tone testing. As shown in Figure 3C, two tone testing using a first frequency f1 and a second frequency f2 can result in tones appears due to both second order intermodulation and third order intermodulation. The magnitude of second order and third order intermodulation components is exacerbated by the capacitance of electrical overvoltage protection structures along RF signal paths. Thus, it is desirable for the capacitance of an electrical overvoltage protection structure to be both low and linear.

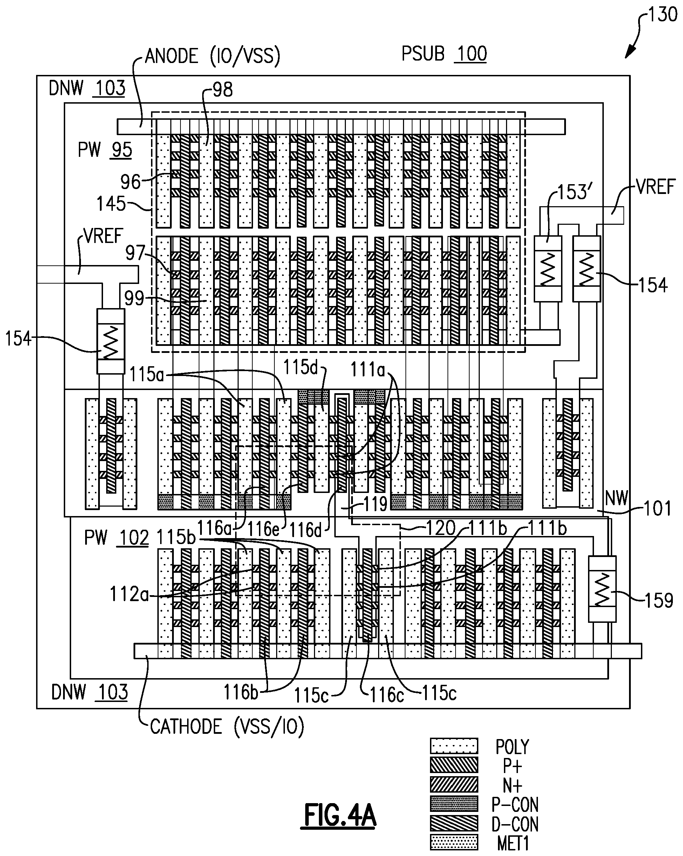

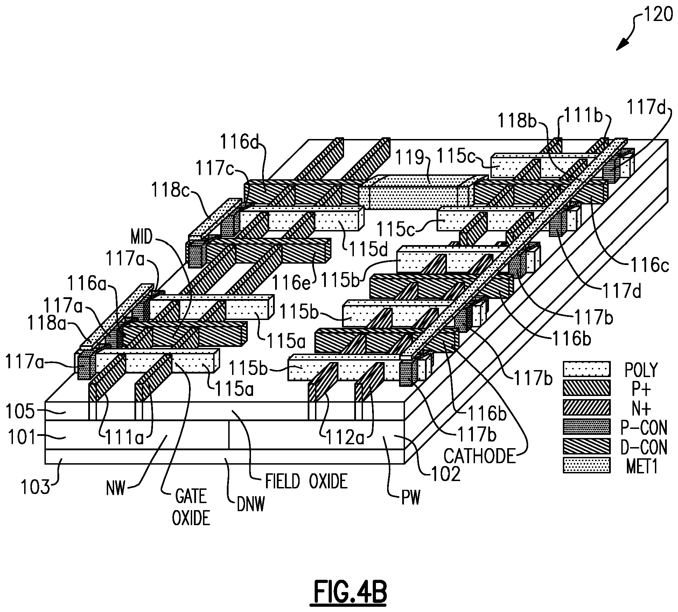

Figure 4A is a plan view of a FinFET SCR-based protection structure 130 according to one embodiment. Figure 4B is a perspective view of an SCR section 120 of the FinFET SCR-based protection structure 130 of Figure 4A.

With reference to Figures 4A and 4B, the FinFET SCR-based protection structure 130 illustrates one embodiment of a chip layout used to implement an SCR protection structure in accordance with the teachings herein. However, the SCR protection structures disclosed herein can be implemented in other ways. One or more instantiations of the FinFET SCR-based protection structure 120 can be included on a semiconductor die to protect circuitry of the die's interface from damage arising from electrical overstress events, such as ESD events.

For example, a first instantiation of the FinFET SCR-based protection structure 130 can have an anode connected to an IO pad and a cathode connected to a VSS pad, and a second instantiation of the FinFET SCR-based protection structure 130 can have an anode connected to the VSS pad and a cathode connected to the IO pad. Connecting a pair of FinFET SCR-based protection structures in this manner provides forward and reverse protection in accordance with the embodiment of Figure 1D discussed above. When including two SCR-based protection structures 130, the structures 130 can be implemented as separate devices with independent semiconductor tubs, or as an embedded structure with an extra junction and bias terminal built-in.

The SCR protection structures herein can include various wells (for instance, n-type well (NW) and/or p-type well (PW) regions), various active regions (for instance, n-type active (N+) and/or p-type active (P+) regions), gates, and/or other structures. As persons of ordinary skill in the art will appreciate, P+ regions have a higher doping concentration than the PWs. Additionally, N+ regions have a higher doping concentration than NWs. Persons having ordinary skill in the art will appreciate various concentrations of dopants in the regions.

It should be appreciated that because regions within a semiconductor device are defined by doping different parts of a semiconductor material with differing impurities or differing concentrations of impurities, discrete physical boundaries between different regions may not actually exist in the completed device but instead regions may transition from one to another. Some boundaries as shown in the figures of this type and are illustrated as abrupt structures merely for the assistance of the reader. As persons having ordinary skill in the art will appreciate, p-type regions can include a p-type semiconductor material, such as boron, as a dopant. Furthermore, n-type regions can include an n-type semiconductor material, such as phosphorous, as a dopant.

With continuing reference to Figures 4A and 4B, the FinFET SCR-based protection structure 130 is fabricated in a p-type substrate (PSUB) 100. Additionally, a deep n-type well (DNW) 103 is formed in the PSUB 100. The DNW 103 serves to electrically isolate NW and PW regions from the PSUB 100.

The FinFET SCR-based protection structure 130 includes a diode section 145 formed in a PW 95. The diode section 145 includes P+ fin regions 96 formed in the PW 95 and connected by metallization to an anode terminal of the FinFET SCR-based protection structure 130. The diode section 145 also includes N+ fin regions 97 formed in the PW and connected by metallization to the SCR section 120. Gate regions 98 are formed over the P+ fin regions 96 and gate regions 99 are formed over the N+ fin regions 97.

The P+ fin regions 96 and PW 95 serve as an anode of the diode section 145, while the N+ fin regions 97 serve as a cathode of the diode section 145. Additionally, inclusion of the gate regions 98/99 enhance a surface conduction of the diode section 145 and achieve a more compact device area relative to a configuration in which trench oxide regions are used to separate diffusion. Not only does a more compact device area achieve a smaller footprint on an IC, but also reduces an amount of metallization and associated parasitics needed for interconnecting fingers of the device.

As shown in Figures 4A and 4B, the SCR section 120 includes an NW 101 and a PW 102 formed adjacent to one another in the DNW 103. Additionally, a first group of P+ fin regions 111a are formed over the NW 101. Additionally, a second group of P+ fin regions 111b are formed in parallel with the first group of P+ fin regions 111a but are of shorter length. Furthermore, a first group of N+ fin regions 112a are formed over the PW 102 and aligned with the second group of P+ fin regions 111b.

In this example, groups of fin regions each include two fins connected in parallel to extend the power handling capability of the structure relative to a configuration with one fin region. However, more or fewer fin regions can be included to achieve a desired current handling capability of the device.

With continuing reference to Figures 4A and 4B, the SCR section 120 further includes various polysilicon gate regions over the NW 101 and the PW 102. The polysilicon gate regions include a first group of polysilicon gate regions 115a formed over the first group of P+ fin regions 111a. Additionally, the SCR section 120 further includes a second group of polysilicon gate regions 115b formed over the first group of N+ fin regions 112a. Furthermore, the SCR section 120 further includes a third group of polysilicon gate regions 115c formed over the second group of P+ fin regions 111b. Additionally, the SCR section 120 further includes a fourth polysilicon gate region 115d formed over the first group of P+ fin regions 111a.

Absent manufacturing variation, the polysilicon gate regions are perpendicular to the active fin regions. Inclusion of the polysilicon gate regions improves the SCR's turn-on speed in response to fast overstress transients. For example, the polysilicon gate regions introduce surface breakdown to lower intrinsic avalanching voltage, thereby lowering trigger voltage.

With continuing reference to Figures 4A and 4B, various metallization including contact metallization (poly contact P-CON and diffusion contact D-CON) and metal one routes (M1) are depicted. The metallization is used in part to form connections that serve to connect various devices to one another as well as to provide terminals for the SCR section 120.

For example, as shown in Figure 4B, the D-CON region 116a connects a portion of the P+ fin regions 111a to the M1 region 118a, which connects to the cathode of the diode section 145. Additionally, the P-CON regions 117a connect the first group of gate regions 115a and the D-CON region 116a to the M1 region 118a. This node corresponds to a mid node MID of the FinFET SCR-based protection structure 130.

The diode section 145 is connected between the anode terminal of the FinFET SCR-based protection structure 130 and the mid node MID, while the SCR section 120 is connected between the mid node MID and the cathode terminal of the FinFET SCR-based protection structure 130.

With continuing reference to Figures 4A and 4B, the P-CON regions 117b connect to the second group of gate regions 115b and are connected using an M1 region 118b used to control the gate potential. In certain implementations, the M1 region 118b is grounded. However, other implementations are possible.

The SCR section 120 includes an NPN bipolar transistor having an emitter, a base, and a collector corresponding to the N+ fin regions 112a, the PW 102, and the NW 101, respectively. Additionally, the SCR section 120 includes a PNP bipolar transistor having an emitter, a base, and a collector corresponding to the P+ fin regions 111a, the NW 101, and the PW 102, respectively.

The SCR section 120 can be fabricated in a variety of advanced technologies, including CMOS FinFET process nodes of 16nm or less.

In certain implementations, a voltage of the NW 101 (corresponding to base voltage of the PNP) is left floating, which serves to reduce a trigger voltage of the SCR section 120. In contrast, conventional diode and SCR protection structures suffer from a large trigger voltage that leads to a large voltage build-up and corresponding damage to circuitry being protected.

The SCR section 120 includes a pair of gate-to-source connected triggering PFETs in series that serve to aid in triggering the SCR in response to an overvoltage condition. The gate of the first triggering PFET is formed by the gate regions 115a, with the gate-to-source connection provided by the M1 region 118a. Additionally, the gate of the second triggering PFET is formed by the gate region 115d, with the M1 region 118c. The SCR section 120 also includes a metal region 119 used to connect the D-CON region 116d to the D-CON region 116c, thereby providing a connection between the source of the second triggering PFET and the PW 102.

Thus, the pair of series gate-to-source connected triggering PFETs are connected from the MID node to the PW 102. Since the PW serves as the base of the SCR's NPN bipolar transistor, a mechanism for current injection and expedited turn-on of the SCR is provided.

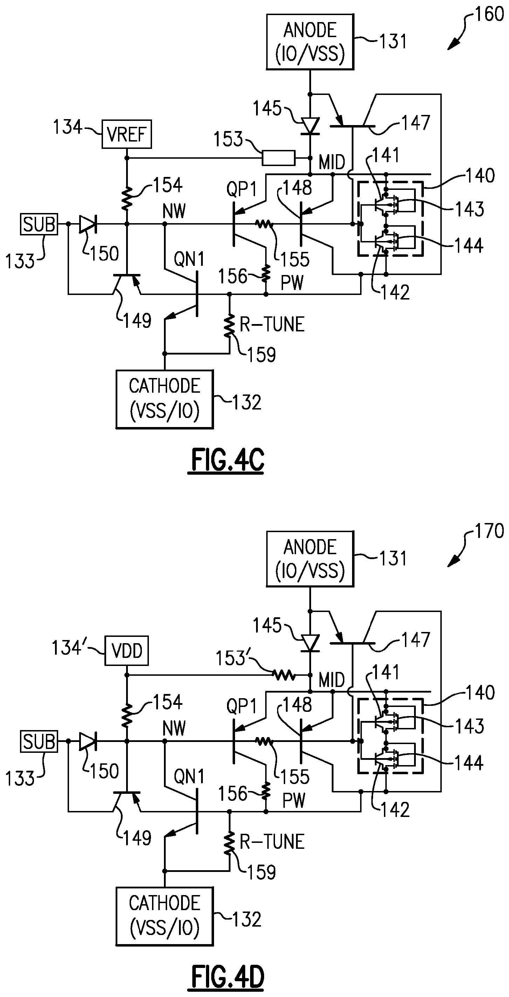

Figure 4C is one embodiment of a circuit diagram 160 of the FinFET SCR-based protection structure 130 of Figures 4A-4B. The FinFET SCR-based protection circuit 160 includes an anode terminal 131, a cathode terminal 132, a substrate terminal 133, a reference voltage terminal 134, a trigger circuit 140, a diode 145, a first PNP bipolar transistor 147, a second PNP bipolar transistor 148, a third PNP bipolar transistor 149, a substrate diode 150, a linearity enhancement impedance 153, an NW bias resistor 154, a base resistor 155, a collector resistor 156, a tuning resistor 159, an SCR PNP bipolar transistor QP1, and an SCR NPN bipolar transistor QN1.

As shown in Figure 4C, the diode 145 is connected between the anode terminal 131 and a mid node MID. Additionally, the SCR PNP bipolar transistor QP1 includes an emitter connected to the mid node MID, a base connected to an NW node, and a collector connected to a PW node through the collector resistor 156. Furthermore, the SCR NPN bipolar transistor QN1 includes an emitter connected to the cathode terminal 132, a base connected to the PW node, and a collector connected to the NW node.

In the illustrated embodiment, the trigger circuit 140 is connected between the mid node MID and the base of the SCR NPN bipolar transistor QN1 (which corresponds to the PW node). The trigger circuit 140 serves to reduce the trigger voltage of the SCR by providing a displacement current to the base of the SCR NPN bipolar transistor QN1 in response to an electrical overstress event. The trigger circuit 140 also serves to reduce DC leakage current of the SCR by biasing the base of the SCR NPN bipolar transistor QN1.

In the illustrated embodiment, the trigger circuit 140 includes a first PNP trigger bipolar transistor 141, a second PNP trigger bipolar transistor 142, a first FinFET trigger PFET 143, and a second FinFET trigger PFET 144. The first FinFET trigger PFET 143 and the second FinFET trigger PFET 144 are connected in series between the mid node MID and base of the SCR NPN bipolar transistor QN1. For example, the source and gate of the first FinFET trigger PFET 143 are connected to the mid node MID, while the drain of the first FinFET trigger PFET 143 is connected to a source and gate of the second FinFET trigger PFET 144. Additionally, the drain of the second FinFET trigger PFET 144 is connected to the base of the SCR NPN bipolar transistor QN1.

As shown in Figure 4C, the first PNP trigger bipolar transistor 141 includes an emitter and a collector connected to the source and drain of the first FinFET trigger PFET 143, respectively. Additionally, the second PNP trigger bipolar transistor 142 includes an emitter and a collector connected to the source and drain of the second FinFET trigger PFET 144, respectively. The bases of the first PNP trigger bipolar transistor 141 and the second PNP trigger bipolar transistor 144 are connected to the NW node through the base resistor 155.

The tuning resistor 159 (of a resistance R-TUNE) is also included between the base of the SCR NPN bipolar transistor QN1 and the cathode terminal 132 to provide fine-tuned control over turn-on characteristics of the SCR. The tuning resistor 159 receives the displacement current from the trigger circuit 140, and thus operates in combination with the trigger circuit 140 to aid in activating the SCR in response to an electrical overstress event.

The linearity enhancement impedance 153 improves linearity performance by blocking a potential path between the anode terminal 131 (through the diode 145) and the reference voltage terminal 134 for RF signals. Furthermore, including the linearity enhancement impedance 153 allows biasing of the mid node MID to a desired electrical potential to achieve low capacitance. The linearity enhancement impedance 153 can correspond to resistors, diodes, switches, and/or other structures that provide impedance.

The NW bias resistor 154 is connected between the reference voltage terminal 134 and the NW node. In combination, the NW bias resistor 154 and the linearity enhancement impedance 153 serve to bias a base-to-emitter junction of the SCR PNP bipolar transistor QP1 to achieve low capacitance. In certain implementations, the reference voltage terminal 134 corresponds to a supply voltage (VDD) terminal. However, other implementations are possible.

With continuing reference to Figure 4C, the first PNP bipolar transistor 147 includes an emitter electrically connected to the anode terminal 131, a base connected to the NW node through the base resistor 155, and a collector connected to the PW node. Additionally, the second PNP bipolar transistor 148 includes an emitter electrically connected to the mid node MID, a base electrically connected to the NW node through the base resistor 155, and a collector connected to the PW node. Furthermore, the third PNP bipolar transistor 149 includes an emitter connected to the PW node, a base connected to the NW node, and a collector connected to the substrate terminal 133. Additionally, the substrate diode 150 includes an anode connected to the substrate terminal 133 and a cathode connected to the NW node.

Figure 4D is another embodiment of a circuit diagram 170 for the FinFET SCR-based protection structure of Figures 4A-4B. The FinFET SCR-based protection circuit 170 of Figure 4D is similar to the FinFET SCR-based protection circuit 160 of Figure 4C, except the FinFET SCR-based protection circuit 170 depicts a specific configuration of a linearity enhancement impedance in which a linearity enhancement resistor 153' is connected between a power supply voltage terminal 134' (VDD) and the mid node MID.

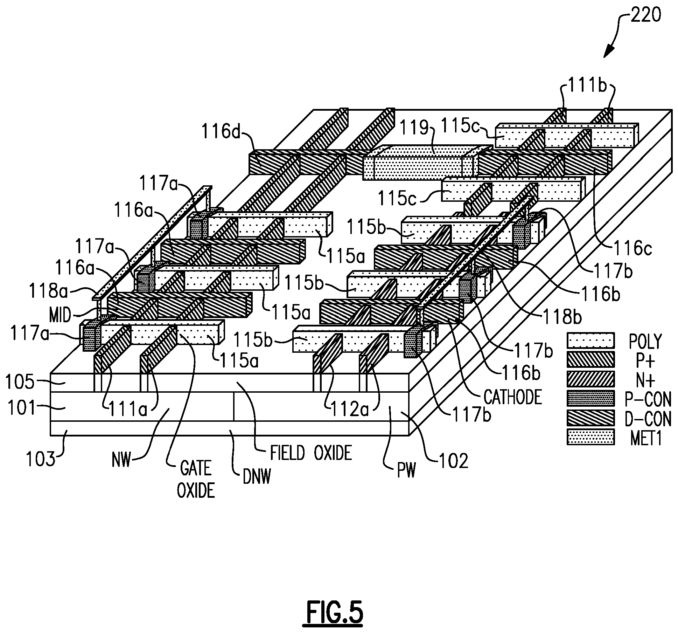

Figure 5 is a perspective view of an SCR section 220 of a FinFET SCR according to another embodiment.

The SCR section 220 an NW 101 and a PW 102 formed adjacent to one another in a DNW 103. Additionally, a first group of P+ fin regions 111a are formed over the NW 101, while a second group of P+ fin regions 111b and a first group of N+ fin regions 112a are formed over the PW 102. Additionally, a first group of polysilicon gate regions 115a are formed over the first group of P+ fin regions 111a, a second group of polysilicon gate regions 115b are formed over the first group of N+ fin regions 115b, and a third group of polysilicon gate regions 115c are formed over the second group of P+ fin regions 111b.

With continuing reference to Figure 5, D-CON regions 116a connect to the first group of P+ fin regions 111a to form a mid node MID. Additionally, P-CON regions 117a connect to the gate regions 115a and to the M1 region 118a to prove a mechanism for controlling the gate potential of the gates over the NW 103. Furthermore, P-CON regions 117b connect to the gate regions 115b and the M1 region 118b to prove a mechanism for controlling the gate potential of the gates over the PW 102. Additionally, the metal region 119 connects the D-CON region 116d to the D-CON region 116c to provide a path in metal for a trigger current to flow.

Segmenting the SCR as depicted in Figure 5 leads to low capacitance and a compact layout.

The SCR section 220 is suitable for FinFET processes that use a dual epitaxial layer (EPI) for growing N+ and P+ fins. For example, the SCR section 220 can be implemented for processes in which separate oxide diffusion (OD) layers are used for defining N+ and P+ diffusion.

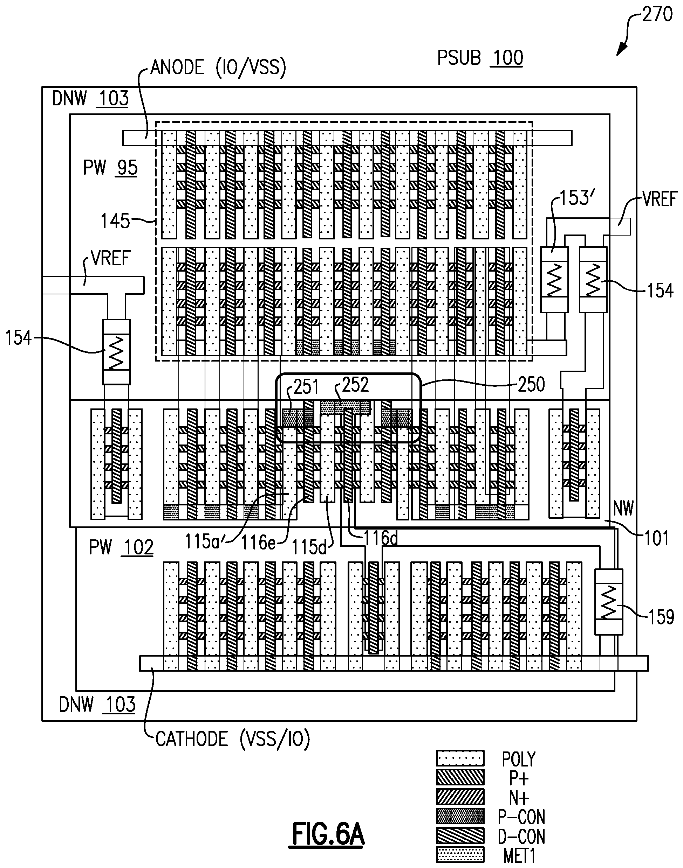

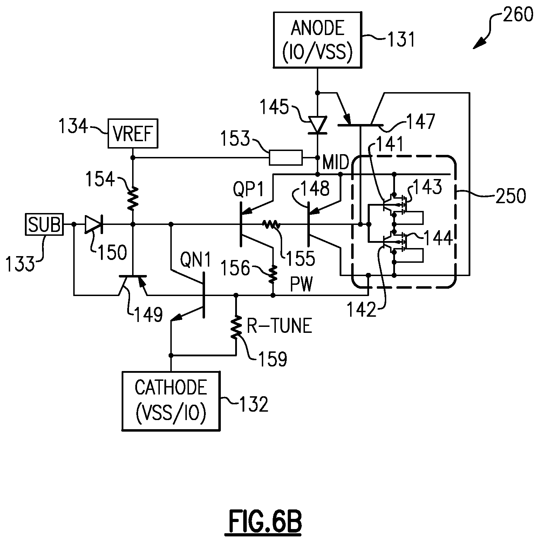

Figure 6A is a plan view of a FinFET SCR 270 according to another embodiment. Figure 6B is one embodiment of a circuit diagram 260 for the FinFET SCR 270 of Figure 6A.

The FinFET SCR-based protection circuit 260 of Figure 6B is similar to the FinFET SCR-based protection circuit 160 of Figure 4C, except the FinFET SCR-based protection circuit 260 depicts a different implementation of a trigger circuit 250 in which the FinFET trigger PFETs are connected from drain to gate rather than from source to gate.

For example, as shown in Figure 6B, the trigger circuit 260 includes a first PNP trigger bipolar transistor 141, a second PNP trigger bipolar transistor 142, a first FinFET trigger PFET 143, and a second FinFET trigger PFET 144. The first FinFET trigger PFET 143 and the second FinFET trigger PFET 144 are connected in series between the mid node MID and base of the SCR NPN bipolar transistor QN1. For example, the source of the first FinFET trigger PFET 143 is connected to the mid node MID, while the drain and gate of the first FinFET trigger PFET 143 is connected to a source of the second FinFET trigger PFET 144. Additionally, the drain and gate of the second FinFET trigger PFET 144 are connected to the base of the SCR NPN bipolar transistor QN1.

By connecting the FinFET trigger PFETs 143/144 with a drain-to-gate connection, a lower trigger voltage is achieved relative to a configuration in which the FinFET trigger PFETs have a source-to-gate connection. Thus, the embodiments of Figures 6A and 6B are suitable for applications with very low trigger voltage.

As shown in Figure 6A, the drain-to-gate connections are made by metal regions 251 and 252. For example, the metal region 251 connects the gate region 115a' (corresponding to the gate of the first FinFET trigger PFET 143) to D-CON region 116e (corresponding to the drain of the first FinFET trigger PFET 143), while the metal region 252 connects the gate region 115d (corresponding to the gate of the second FinFET trigger PFET 144) to D-CON region 116d (corresponding to the drain of the second FinFET trigger PFET 144).

### Applications

Devices employing the above described schemes can be implemented into various electronic devices. Examples of the electronic devices can include, but are not limited to, consumer electronic products, parts of the consumer electronic products, electronic test equipment, communication infrastructure applications, etc. Further, the electronic device can include unfinished products, including those for communication, industrial, medical and automotive applications.

### Conclusion

The foregoing description may refer to elements or features as being "connected" or "coupled" together. As used herein, unless expressly stated otherwise, "connected" means that one element/feature is directly or indirectly connected to another element/feature, and not necessarily mechanically. Likewise, unless expressly stated otherwise, "coupled" means that one element/feature is directly or indirectly coupled to another element/feature, and not necessarily mechanically. Thus, although the various schematics shown in the figures depict example arrangements of elements and components, additional intervening elements, devices, features, or components may be present in an actual embodiment (assuming that the functionality of the depicted circuits is not adversely affected).

While certain embodiments have been described, these embodiments have been presented by way of example only, and are not intended to limit the scope of the disclosure. Indeed, the novel apparatus, methods, and systems described herein may be embodied in a variety of other forms; furthermore, various omissions, substitutions and changes in the form of the methods and systems described herein may be made without departing from the scope of the disclosure. Accordingly, the scope of the present invention is defined only by the appended claims.

## Claims

1. An overvoltage protection circuit (160) for protecting a radio frequency, RF, signal pad (131) and a ground pad (132) of an integrated circuit, IC (10), wherein the overvoltage protection circuit comprises:
a first fin field-effect transistor, FinFET, silicon controlled rectifier, SCR (51), including a first PNP bipolar transistor (QP1) and a first NPN bipolar transistor (QN1), wherein a collector of first NPN bipolar transistor is connected to a base of the first PNP bipolar transistor, and a base of the first NPN bipolar transistor is connected to a collector of the first PNP bipolar transistor;
a fin field-effect transistor, FinFET, trigger circuit (140) connected between an emitter of the first PNP bipolar transistor and the base of the first NPN bipolar transistor; and
a linearity enhancement impedance (153) connected between a reference voltage terminal and the emitter of the first PNP bipolar transistor, the linearity enhancement impedance configured to inhibit coupling of a RF signal from the RF signal pad to the reference voltage terminal.

2. The overvoltage protection circuit (160) of Claim 1, wherein the overvoltage protection circuit further comprises a FinFET diode (145) having a cathode connected to the emitter of the PNP bipolar transistor, wherein an anode of the FinFET diode is connected to the RF signal pad (131), and an emitter of the NPN bipolar transistor is connected to the ground pad (132).

3. An integrated circuit, IC, (10) comprising:
a radio frequency, RF, signal pad (131) and a ground pad (132); and
an overvoltage protection circuit (160) according to claim 1 or 2 connected between the RF signal pad and the ground pad and configured to activate in response to an electrical overvoltage condition received between the RF signal pad and the ground pad.

4. The IC (10) of Claim 3, wherein the FinFET trigger circuit (140) includes a first FinFET transistor (143) and a second FinFET transistor (144) in series.

5. The IC (10) of Claim 4, wherein a gate of the first FinFET transistor (143) is connected to a source of the first FinFET transistor and to the emitter of the first PNP bipolar transistor, and wherein a gate of the second FinFET transistor (144) is connected to a source of the second FinFET transistor and to a drain of the first FinFET transistor
and/or
wherein a gate of the first FinFET transistor is connected to a drain of the first FinFET transistor and to a source of the second FinFET transistor, and wherein a gate of the second FinFET transistor is connected to a drain of the second FinFET transistor and to the base of the first NPN bipolar transistor.

6. The IC (10) of any of Claims 3 to 5, further comprising an n-type field-effect transistor, NFET (33), and a p-type field-effect transistor, PFET (34), each having a source configured to receive the RF signal, the IC further comprising at least one of an n-well biasing circuit (46) for biasing a body of the PFET or a p-well biasing circuit (45) for biasing a body of the NFET.

7. The IC (10) of any of Claims 3 to 6, wherein the overvoltage protection circuit further comprises a second FinFET diode having an anode connected to the ground pad, a second FinFET SCR having an anode connected to a cathode of the second FinFET diode and a cathode connected to the RF signal pad.

8. The IC (10) of any of Claims 3 to 7, wherein the linearity enhancement impedance (153) includes a resistor connected between the reference voltage terminal (134) and the emitter of the PNP bipolar transistor (QP1).

9. The IC (10) of any of Claims 3 to 8, wherein the overvoltage protection circuit (160) further includes a bias resistor (154) connected between the reference voltage terminal (134) and the base of the PNP bipolar transistor (QP1)
and/or
wherein the IC further comprises a tuning resistor (159) connected between the base of the NPN bipolar transistor and an emitter of the NPN bipolar transistor.

10. The IC (10) of any of Claims 3 to 9, wherein the reference voltage terminal (134) is a supply voltage terminal.

11. The IC (10) of any of Claims 3 to 10, further comprising:
an n-type well (NW) forming the base of the PNP bipolar transistor and the collector of the NPN bipolar transistor;
a p-type well (PW) formed adjacent to the NW and forming the base of the NPN bipolar transistor and the collector of the PNP bipolar transistor;
a plurality of p-type active (P+) fin regions over the NW and forming the emitter of the PNP bipolar transistor; and
a plurality of n-type active (N+) fin regions over the PW and forming the emitter of the NPN bipolar transistor.

12. The IC (10) of Claim 11, further comprising a first plurality of polysilicon gate regions (115a) formed over the NW and the plurality of P+ fin regions, and a second plurality of polysilicon gate regions (115b) formed over the PW and the plurality of N+ fin regions.

13. The IC (10) of Claim 12, wherein the FinFET trigger circuit (140) is formed in the NW, wherein the overvoltage protection circuit includes a metal conductor configured to carry a trigger current from the FinFET trigger circuit to the PW.

14. The IC (10) of Claim 12 or 13, wherein the plurality of P+ fin regions, the plurality of N+ fin regions, the first plurality of polysilicon regions (115a), and the second plurality of polysilicon regions (115b) form a plurality of FinFET SCR segments that are interconnected to one another by metallization.

15. A method of protecting an integrated circuit, IC (10), from electrical overstress, the method comprising:
receiving an electrical overvoltage condition between a radio frequency, RF, signal pad (131) and a ground pad (132);
conducting a trigger current in response to the electrical overvoltage condition using a fin field-effect transistor, FinFET, trigger circuit (140) that is connected between an emitter of a first PNP bipolar transistor and a base of a first NPN bipolar transistor;
activating the FinFET silicon controlled rectifier, SCR (51), in response to the trigger current, wherein the FinFET SCR (51) includes the first PNP bipolar transistor (QP1) and the first NPN bipolar transistor (QN1), wherein a collector of first NPN bipolar transistor is connected to a base of the first PNP bipolar transistor, and a base of the first NPN bipolar transistor is connected to a collector of the first PNP bipolar transistor; and
inhibiting coupling of a RF signal from the RF signal pad (131) using a linearity enhancement impedance (153) connected between a reference voltage terminal and the emitter of the first PNP bipolar transistor.

## Patentansprüche

1. Überspannungsschutz-Schaltung (160) zum Schützen einer Hochfrequenz-, HF-Signalkontaktfläche (131) und einer Masse-Kontaktfläche (132) einer integrierten Schaltung, IC (10), wobei die Überspannungsschutz-Schaltung umfasst:
einen ersten Finnen-Feldeffekttransistor-, FinFET-, siliziumgesteuerten Gleichrichter, SCR (51), der einen ersten bipolaren PNP-Transistor (QP1) und einen ersten bipolaren NPN-Transistor (QN1) einschließt, wobei ein Kollektor eines ersten bipolaren NPN-Transistors mit einer Basis des ersten bipolaren PNP-Transistors verbunden ist und eine Basis des ersten bipolaren NPN-Transistors mit einem Kollektor des ersten bipolaren PNP-Transistors verbunden ist;
Finnen-Feldeffekttransistor-, FinFET-Auslöseschaltung (140), die zwischen einem Emitter des ersten bipolaren PNP-Transistors und der Basis des ersten bipolaren NPN-Transistors verbunden ist; und
eine die Linearität verbessernde Impedanz (153), die zwischen einem Referenzspannungsanschluss und dem Emitter des ersten bipolaren PNP-Transistors verbunden ist, wobei die Linearität verbessernde Impedanz konfiguriert ist, um ein Koppeln eines HF-Signals von der HF-Signalkontaktfläche zum Referenzspannungsanschluss zu unterdrücken.

2. Überspannungsschutz-Schaltung (160) nach Anspruch 1, wobei die Überspannungsschutz-Schaltung weiter eine FinFET-Diode (145) umfasst, die eine Kathode aufweist, die mit dem Emitter des bipolaren PNP-Transistors verbunden ist, wobei eine Anode der FinFET-Diode mit der HF-Signalkontaktfläche (131) verbunden ist und ein Emitter des bipolaren NPN-Transistors mit der Masse-Kontaktfläche (132) verbunden ist.

3. Integrierte Schaltung, IC, (10), umfassend:
eine Hochfrequenz-, HF-, Signalkontaktfläche (131) und eine Masse-Kontaktfläche (132); und
eine Überspannungsschutz-Schaltung (160) nach Anspruch 1 oder 2, die zwischen der HF-Signalkontaktfläche und der Masse-Kontaktfläche verbunden ist und konfiguriert ist, um als Reaktion auf einen elektrischen Überspannungszustand, der zwischen der HF-Signalkontaktfläche und der Masse-Kontaktfläche empfangen wird, aktiviert zu werden.

4. IC (10) nach Anspruch 3, wobei die FinFET-Auslöseschaltung (140) einen ersten FinFET-Transistor (143) und einen zweiten FinFET-Transistor (144) in Reihe einschließt.

5. IC (10) nach Anspruch 4, wobei ein Gate des ersten FinFET-Transistors (143) mit einer Source des ersten FinFET-Transistors und mit dem Emitter des ersten bipolaren PNP-Transistors verbunden ist, und wobei ein Gate des zweiten FinFET-Transistors (144) mit einer Source des zweiten FinFET-Transistors und mit einem Drain des ersten FinFET-Transistors verbunden ist
und/oder
wobei ein Gate des ersten FinFET-Transistors mit einem Drain des ersten FinFET-Transistors und mit einer Source des zweiten FinFET-Transistors verbunden ist, und wobei ein Gate des zweiten FinFET-Transistors mit einem Drain des zweiten FinFET-Transistors und mit der Basis des ersten bipolaren NPN-Transistors verbunden ist.

6. IC (10) nach einem der Ansprüche 3 bis 5, weiter umfassend einen Feldeffekttransistor vom n-Typ, NFET (33), und einen Feldeffekttransistor vom p-Typ, PFET (34), die jeweils eine Source aufweisen, die konfiguriert ist, um das HF-Signal zu empfangen, wobei die IC weiter mindestens eine von einer n-well-Vorspannungsschaltung (46) zum Vorspannen eines Gehäuses des PFET oder eine p-well-Vorspannungsschaltung (45) zum Vorspannen eines Gehäuses des NFET umfasst.

7. IC (10) nach einem der Ansprüche 3 bis 6, wobei die Überspannungsschutz-Schaltung weiter eine zweite FinFET-Diode, die eine Anode aufweist, die mit der Masse-Kontaktfläche verbunden ist, einen zweiten FinFET-SCR, der eine Anode aufweist, die mit einer Kathode der zweiten FinFET-Diode verbunden ist, und eine Kathode, die mit der HF-Signalkontaktfläche verbunden ist, umfasst.

8. IC (10) nach einem der Ansprüche 3 bis 7, wobei die Linearität verbessernde Impedanz (153) einen Widerstand einschließt, der zwischen dem Referenzspannungsanschluss (134) und dem Emitter des bipolaren PNP-Transistors (QP1) verbunden ist.

9. IC (10) nach einem der Ansprüche 3 bis 8, wobei die Überspannungsschutz-Schaltung (160) weiter einen Vorspannungswiderstand (154) einschließt, der zwischen dem Referenzspannungsanschluss (134) und der Basis des bipolaren PNP-Transistors (QP1) verbunden ist
und/oder
wobei die IC weiter einen Abgleichwiderstand (159) umfasst, der zwischen der Basis des bipolaren NPN-Transistors und einem Emitter des bipolaren NPN-Transistors verbunden ist.

10. IC (10) nach einem der Ansprüche 3 bis 9, wobei der Referenzspannungsanschluss (134) ein Versorgungsspannungsanschluss ist.

11. IC (10) nach einem der Ansprüche 3 bis 10, weiter umfassend:
eine n-Typ-Wanne (NW), die eine Basis des bipolaren PNP-Transistors und den Kollektor des bipolaren NPN-Transistors bildet;
eine p-Typ-Wanne (PW), die an die NW angrenzend gebildet ist und die Basis des bipolaren NPN-Transistors und den Kollektor des bipolaren PNP-Transistors bildet;
eine Vielzahl von aktiven (P+)-Finnenbereichen vom p-Typ über der NW, und den Emitter des bipolaren PNP-Transistors bildend; und
eine Vielzahl von aktiven (N+)-Finnenbereichen vom n-Typ über der PW, und den Emitter des bipolaren NPN-Transistors bildend.

12. IC (10) nach Anspruch 11, weiter umfassend eine erste Vielzahl von Polysilizium-Gatebereichen (115a), die über der NW und der Vielzahl von P+-Finnenbereichen gebildet sind, und eine zweite Vielzahl von Polysilizium-Gatebereichen (115b), die über der PW und der Vielzahl von N+-Finnenbereichen gebildet sind.

13. IC (10) nach Anspruch 12, wobei die FinFET-Auslöseschaltung (140) in der NW gebildet ist, wobei die Überspannungsschutz-Schaltung einen Metallleiter einschließt, der konfiguriert ist, um einen Auslösestrom von der FinFET-Auslöseschaltung zur PW zu führen.

14. IC (10) nach Anspruch 12 oder 13, wobei die Vielzahl von P+-Finnenbereichen, die Vielzahl von N+-Finnenbereichen, die erste Vielzahl von Polysiliziumbereichen (115a) und die zweite Vielzahl von Polysiliziumbereichen (115b) eine Vielzahl von FinFET-SCR-Segmenten bilden, die durch Metallisierung miteinander verbunden sind.

15. Verfahren zum Schützen einer integrierten Schaltung, IC (10), vor elektrischer Überlastung, wobei das Verfahren umfasst:
Empfangen eines elektrischen Überspannungszustands zwischen einer Hochfrequenz-, HF-, Signalkontaktfläche (131) und einer Masse-Kontaktfläche (132);
Leiten eines Auslösestroms als Reaktion auf den elektrischen Überspannungszustand unter Verwendung einer Finnen-Feldeffekttransistor-, FinFET-Auslöseschaltung (140), die zwischen einem Emitter eines ersten bipolaren PNP-Transistors und einer Basis eines ersten bipolaren NPN-Transistors verbunden ist;
Aktivieren des FinFET-siliziumgesteuerten Gleichrichters, SCR (51), als Reaktion auf den Auslösestrom, wobei der FinFET-SCR (51) den ersten bipolaren PNP-Transistor (QP1) und den ersten bipolaren NPN-Transistor (QN1) einschließt,
wobei ein Kollektor des ersten bipolaren NPN-Transistors mit einer Basis des ersten bipolaren PNP-Transistors verbunden ist und eine Basis des ersten bipolaren NPN-Transistors mit einem Kollektor des ersten bipolaren PNP-Transistors verbunden ist; und
Unterdrücken des Koppelns eines HF-Signals von der HF-Signalkontaktfläche (131) unter Verwendung einer Linearität verbessernden Impedanz (153), die zwischen einem Referenzspannungsanschluss und dem Emitter des ersten bipolaren PNP-Transistors verbunden ist.

## Revendications

1. Circuit (160) de protection contre les surtensions pour protéger une pastille (131) de signal radiofréquence, RF, et une pastille de terre (132) d'un circuit intégré, IC (10), dans lequel le circuit de protection contre les surtensions comprend :
un premier redresseur commandé au silicium, SCR (51) à transistor à effet de champ à ailettes, FinFET, incluant un premier transistor bipolaire PNP (QP1) et un premier transistor bipolaire NPN (QN1), dans lequel un collecteur du premier transistor bipolaire NPN est relié à une base du premier transistor bipolaire PNP, et une base du premier transistor bipolaire NPN est reliée à un collecteur du premier transistor bipolaire PNP ;
un circuit (140) de déclenchement à transistor à effet de champ à ailettes, FinFET, relié entre un émetteur du premier transistor bipolaire PNP et la base du premier transistor bipolaire NPN ; et
une impédance (153) d'amélioration de la linéarité reliée entre une terminaison de tension de référence et l'émetteur du premier transistor bipolaire PNP, l'impédance d'amélioration de la linéarité étant configurée pour inhiber le couplage d'un signal RF da la pastille de signal RF à la terminaison de tension de référence.

2. Circuit (160) de protection contre les surtensions selon la revendication 1, dans lequel le circuit de protection contre les surtensions comprend en outre une diode FinFET (145) présentant une cathode reliée à l'émetteur du transistor bipolaire PNP, dans lequel une anode de la diode FinFET est reliée à la pastille (131) de signal RF, et un émetteur du transistor bipolaire NPN est relié à la pastille de terre (132).

3. Circuit intégré, CI, (10) comprenant :
une pastille (131) de signal radiofréquence, RF, et une pastille de terre (132) ; et
un circuit (160) de protection contre les surtensions selon la revendication 1 ou la revendication 2 relié entre la pastille de signal RF et la pastille de terre et configuré pour s'activer en réponse à une condition de surtension électrique reçue entre la pastille de signal RF et la pastille de terre.

4. CI (10) selon la revendication 3, dans lequel le circuit (140) de déclenchement FinFET inclut un premier transistor FinFET (143) et un deuxième transistor FinFET (144) en série.

5. CI (10) selon la revendication 4, dans lequel une grille du premier transistor FinFET (143) est reliée à une source du premier transistor FinFET et à l'émetteur du premier transistor bipolaire PNP, et dans lequel une grille du deuxième transistor FinFET (144) est reliée à une source du deuxième transistor FinFET et à un drain du premier transistor FinFET et/ou
dans lequel une grille du premier transistor FinFET est reliée à un drain du premier transistor FinFET et à une source du deuxième transistor FinFET, et dans lequel une grille du deuxième transistor FinFET est reliée à un drain du deuxième transistor FinFET et à la base du premier transistor bipolaire NPN.

6. CI (10) selon l'une quelconque des revendications 3 à 5, comprenant en outre un transistor à effet de champ de type n, NFET (33), et un transistor à effet de champ de type p, PFET (34), présentant chacun une source configurée pour recevoir le signal RF, le CI comprenant en outre au moins un parmi un circuit (46) de polarisation de puits de type n pour polariser un corps du PFET ou un circuit (45) de polarisation de puits de type p pour polariser un corps du NFET.

7. CI (10) selon l'une quelconque des revendications 3 à 6, dans lequel le circuit de protection contre les surtensions comprend en outre une deuxième diode FinFET présentant une anode reliée à la pastille de terre, un deuxième SCR FinFET présentant une anode reliée à une cathode de la deuxième diode FinFET et une cathode reliée à la pastille de signal RF.

8. CI (10) selon l'une quelconque des revendications 3 à 7, dans lequel l'impédance (153) d'amélioration de la linéarité inclut une résistance reliée entre la terminaison (134) de tension de référence et l'émetteur du transistor bipolaire PNP (QP1).

9. CI (10) selon l'une quelconque des revendications 3 à 8, dans lequel le circuit (160) de protection contre les surtensions inclut en outre une résistance de polarisation (154) reliée entre la terminaison (134) de tension de référence et la base du transistor bipolaire PNP (QP1)
et/ou
dans lequel le CI comprend en outre une résistance de réglage (159) reliée entre la base du transistor bipolaire NPN et un émetteur du transistor bipolaire NPN.

10. CI (10) selon l'une quelconque des revendications 3 à 9, dans lequel la terminaison (134) de tension de référence est une terminaison de tension d'alimentation.

11. CI (10) selon l'une quelconque des revendications 3 à 10, comprenant en outre :
un puits de type n (NW) formant la base du transistor bipolaire PNP et le collecteur du transistor bipolaire NPN ;
un puits de type p (PW) formé adjacent au NW et formant la base du transistor bipolaire NPN et le collecteur du transistor bipolaire PNP ;
une pluralité de régions d'ailettes actives de type p (P+) sur le NW et formant l'émetteur du transistor bipolaire PNP ; et
une pluralité de régions d'ailettes actives de type n (N+) sur le PW et formant l'émetteur du transistor bipolaire NPN.

12. CI (10) selon la revendication 11, comprenant en outre une première pluralité de régions (115a) de grille en polysilicium formées sur le NW et la pluralité de régions d'ailettes P+, et une deuxième pluralité de régions (115b) de grille en polysilicium formées sur le PW et la pluralité de régions d'ailettes N+.

13. CI (10) selon la revendication 12, dans lequel le circuit (140) de déclenchement FinFET est formé dans le NW, dans lequel le circuit de protection contre les surtensions inclut un conducteur métallique configuré pour porter un courant de déclenchement du circuit de déclenchement FinFET au PW.

14. CI (10) selon la revendication 12 ou la revendication 13, dans lequel la pluralité de régions d'ailettes P+, la pluralité de régions d'ailettes N+, la première pluralité de régions en polysilicium (115a), et la deuxième pluralité de régions en polysilicium (115b) forment une pluralité de segments de SCR FinFET qui sont interreliés les uns aux autres par métallisation.

15. Procédé de protection d'un circuit intégré, CI (10), contre une surcharge électrique, le procédé comprenant :
la réception d'une condition de surtension électrique entre une pastille (131) de signal de radiofréquence, RF, et une pastille de terre (132) ;
la conduite d'un courant de déclenchement en réponse à la condition de surtension électrique en utilisant un circuit (140) de déclenchement à transistor à effet de champ à ailettes, FinFET, qui est relié entre un émetteur d'un premier transistor bipolaire PNP et une base d'un premier transistor bipolaire NPN ;
l'activation du redresseur commandé, SCR (51) au silicium FinFET, en réponse au courant de déclenchement,
dans lequel le SCR FinFET (51) inclut le premier transistor bipolaire PNP (QP1) et le premier transistor bipolaire NPN (QN1),
dans lequel un collecteur du premier transistor bipolaire NPN est relié à une base du premier transistor bipolaire PNP, et une base du premier transistor bipolaire NPN est reliée à un collecteur du premier transistor bipolaire PNP ; et
l'inhibition du couplage d'un signal RF à partir de la pastille (131) de signal RF en utilisant une impédance (153) d'amélioration de la linéarité reliée entre une terminaison de tension de référence et l'émetteur du premier transistor bipolaire PNP.
